# EUROPEAN PATENT APPLICATION

(11) **EP 4 585 502 A1**
(43) Date of publication of application: **16.07.2025**
(21) Application number: 23862227.8
(22) Date of filing: 29.08.2023
(51) Int. Cl.: B63B 17/00, H02J 3/38, F03D 9/25, F03D 9/32, F03D 7/04, B63B 49/00

(54) **SUPERCOMPUTING CENTER SYSTEM**

(30) Priority: 06.09.2022 CN 202211086923
(71) Applicant: Bitmain Technologies Inc., Beijing 100094 (CN)
(72) Inventor: LI, Cheng, Beijing 100094 (CN); ZENG, Hongbo, Beijing 100094 (CN); HAO, Mingliang, Beijing 100094 (CN); WU, Guo, Beijing 100094 (CN); BAI, Qiwei, Beijing 100094 (CN); GENG, Tuo, Beijing 100094 (CN)
(74) Representative: Dr. Gassner & Partner mbB
(86) International application number: PCT/CN2023/115555
(87) International publication number: WO 2024/051532

(57) **Abstract**

The present application discloses a supercomputing center system, which includes a wind-powered vessel, and a damping device, at least one supercomputing device, a control device, and a wind power generation device that are arranged on the hull of the wind-powered vessel. The damping device is configured to maintain the stability of the hull; the supercomputing device is configured to perform operations; the control device controls the wind power generation device to generate power and adjusts the angles of the damping device based on real-time sea condition information; and the wind power generation device supplies power to the supercomputing device, the damping device, and the control device.

## Description

The present application claims priority to the Chinese Patent Application No. 202211086923.4, filed with the China National Intellectual Property Administration on September 6, 2022 and titled "SUPERCOMPUTING CENTER SYSTEM", which is hereby incorporated by reference in its entirety.

### TECHNICAL FIELD

The present application relates to the field of supercomputing centers, and specifically to a supercomputing center system.

### BACKGROUND

With the rapid development of information technology, the cloud era has quietly arrived. As the demand for data storage and computing resources increases rapidly, the heat dissipation of a supercomputing center has also become very large. In order to maintain a stable work, an extremely huge and complex heat dissipation device needs to be arranged on a traditional supercomputing center, electric energy consumption of which may account for about 40% of the total power of the entire supercomputing center. The arrangement and maintenance of the heat dissipation device are a huge burden in terms of cost and labor.

The inventors realized that currently, an offshore supercomputing center based on natural cooling is a strategic direction for the arrangement of supercomputing center. However, it is a huge challenge to solve the problem of the electric load of the supercomputing center. Although a combination of offshore wind power and the supercomputing center may satisfy the requirement for the electric load, the stability of a current commonly-used offshore cargo-carrying platform (e.g., a floating platform), when carrying a wind turbine, cannot satisfy the requirement of a fan blade of the wind turbine for a rolling angle of the cargo-carrying platform.

### TECHNICAL PROBLEM

At present, the offshore supercomputing center according to natural cooling is the strategic direction for the arrangement of supercomputing center. However, it is a huge challenge to solve the problem of the electric load of the supercomputing center. Although the combination of the offshore wind power and the supercomputing center may satisfy the requirement for the electric load, the stability of the current commonly-used offshore cargo-carrying platform (e.g., the floating platform), when carrying the wind turbine, cannot satisfy the requirement of the fan blade of the wind turbine for the rolling angle of the cargo-carrying platform.

### TECHNICAL SOLUTION

A supercomputing center system includes: a wind-powered vessel, the wind-powered vessel including a hull; a damping device, connected with the hull and configured to maintain the stability of the hull; at least one supercomputing device, arranged on the hull and configured to perform operations; a control device, arranged on the hull and communicatively connected with the supercomputing device and the damping device; a wind power generation device, arranged on the hull and configured to supply electric energy to the supercomputing device, the damping device and the control device; where the control device is configured to: generate wind turbine parameter information and damping angle information according to real-time sea state information of a sea area where the wind-powered vessel is located, and control the wind power generation device to generate electric energy and adjust an angle of the damping device according to the wind turbine parameter information and the damping angle information; and generate a deployment signal for deploying the electric energy of the wind power generation device according to amount of electric energy consumption of the control device, the damping device and the supercomputing device.

### BENEFICIAL EFFECTS

It solves the problem of excessive electric energy consumption costs of existing supercomputing center systems arranged on the ground. It also improves the stability of the supercomputing center system by utilizing a double-vessel connection combined with a multi-point mooring structure, which satisfies the requirement of a fan blade of a wind turbine for a rolling angle of a cargo-carrying platform and solves the problem of insufficient stability of existing offshore cargo-carrying platforms, thereby realizing the islanded grid operation of an offshore supercomputing center.

### BRIEF DESCRIPTION OF DRAWINGS

In order to more clearly illustrate the technical solutions of embodiments of the present application, the drawings needed to be used in the description of the embodiments will be briefly introduced below. Obviously, the drawings in the following description are some embodiments of the present application, and those skilled in the art can also obtain other drawings according to these drawings without exerting creative work.
FIG. 1 is a schematic structural diagram of a supercomputing center system provided by an embodiment of the present application.
FIG. 2 is a schematic block diagram of a damping device provided by an embodiment of the present application.
FIG. 3 is a schematic block diagram of a supercomputing device provided by an embodiment of the present application.
FIG. 4 is a schematic block diagram of a control device provided by an embodiment of the present application.
FIG. 5 is a schematic structural diagram of a wind power generation device provided by an embodiment of the present application.
FIG. 6 is a schematic structural diagram of another supercomputing center system provided by an embodiment of the present application.

### Description of main components and symbols:

100, supercomputing center system; 11, wind-powered vessel; 111, hull; 11a, first vessel; 11b, second vessel; 12, damping device; 121, damping plate; 122, power apparatus; 13, supercomputing device; 131, supercomputing apparatus; 132, water-cooling apparatus; 133, container; 14, control device; 141, communication apparatus; 142, control apparatus; 15, wind power generation device; 151, tower; 152, wind turbine; 153, fan blade; 16, energy storage device; 17, mooring device; 171, counterweight block; 172, mooring cable; 18, connecting device.

### SUMMARY

Embodiments of the present application provide a supercomputing center system, which utilizes the offshore wind power technology, i.e., a green energy supply method, to supply electric energy to a supercomputing center, thereby solving the problem of excessive electric energy consumption costs, and which also adopts a dual-vessel connection combined with a multi-point mooring structure, thereby solving the problem of insufficient stability of existing offshore cargo-carrying platforms and realizing the islanded grid operation of the supercomputing center.

The present application provides a supercomputing center system. The supercomputing center system includes:
a wind-powered vessel, including a hull;
a damping device, connected with the hull and configured to maintain stability of the hull;
at least one supercomputing device, arranged on the hull and configured to perform operations;
a control device, arranged on the hull and communicatively connected with the supercomputing device and the damping device;
a wind power generation device, arranged on the hull and configured to supply electric energy to the supercomputing device, the damping device and the control device;
where the control device is configured to: generate wind turbine parameter information and damping angle information according to real-time sea state information of a sea area where the wind-powered vessel is located, and control the wind power generation device to generate electric energy and adjust an angle of the damping device according to the wind turbine parameter information and the damping angle information; and generate a deployment signal for deploying the electric energy of the wind power generation device according to amount of electric energy consumption of the control device, the damping device and the supercomputing device.

In some embodiments, the damping device includes a damping plate and a power apparatus. One end of the power apparatus is connected to the damping plate, and the other end of the power apparatus is connected with the hull. The power apparatus is electrically connected to the wind power generation device, and the power apparatus is communicatively connected to the control device. The wind power generation device is configured to supply electric energy to the power apparatus, and the control device is configured to adjust an angle of the damping plate through the power apparatus according to the damping angle information, so as to complete an adjustment of the angle of the damping device.

In some embodiments, the supercomputing device includes: a container, a supercomputing device, and a water-cooling apparatus. The container is arranged on the hull, and the supercomputing apparatus and the water-cooling apparatus are installed within the container. The water-cooling apparatus is configured to cool the supercomputing apparatus.

In some embodiments, the wind power generation device includes: a tower, a wind turbine and at least one fan blade. The tower is arranged on the hull, and the wind turbine is arranged on a top portion of the tower. The fan blade is rotationally connected to the wind turbine, and an axial direction of rotation of the fan blade is set at a preset angle with respect to a bow direction of the wind-powered vessel. The wind turbine is electrically connected to the control device and the wind power generation device. The wind power generation device is configured to supply electric energy to the wind turbine. The control device is configured to adjust the rotation of the fan blade through the wind turbine according to the wind turbine parameter information.

In some embodiments, the supercomputing center system includes: an energy storage device. The energy storage device is arranged on the hull. The energy storage device is electrically connected to the wind power generation device and is configured to store electric energy. The energy storage device is also configured to supply electric energy to the supercomputing device, the damping device and the control device.

In some embodiments, the generating the deployment signal for deploying the electric energy of the wind power generation device according to the amount of electric energy consumption of the control device, the damping device and the supercomputing device includes: comparing, by the control device, the electric energy generated by the wind power generation device with the electric energy of the deployment signal; when the electric energy generated by the wind power generation device is greater than the electric energy of the deployment signal, generating, by the control device, a new deployment signal for deploying and transmitting remaining electric energy of the wind power generation device to the energy storage device for storage.

In some embodiments, the generating the deployment signal for deploying the electric energy of the wind power generation device according to the amount of electric energy consumption of the control device, the damping device and the supercomputing device includes: when the electric energy generated by the wind power generation device is less than the electric energy of the deployment signal, generating, by the control device, a new deployment signal for deploying electric energy of the energy storage device.

In some embodiments, the supercomputing center system includes multiple mooring devices. A mooring device includes a mooring cable and a counterweight block. One end of the mooring cable is connected to the vessel, and the other end of the mooring cable is connected to the counterweight block.

In some embodiments, the supercomputing center-based system includes: a first vessel, a second vessel, and a connecting device, where both the first vessel and the second vessel serve as the wind-powered vessel, and the connecting device connects the first vessel and the second vessel.

In some embodiments, the supercomputing center system includes: the mooring cable between the first vessel and the second vessel being connected to the same counterweight block.

The supercomputing center system disclosed by the present application builds an offshore electric energy supply system of the supercomputing center, which obtains control information of various components related to offshore wind power according to real-time sea state information, and drives the operation of the components according to the control information of the various components to realize the electric energy supply of the supercomputing center. The supercomputing center system provided by the present application solves the problem of excessive electric energy consumption costs of existing supercomputing center systems arranged on the ground, and improves the stability of the supercomputing center system by using a double-vessel connection combined with a multi-point mooring structure, which satisfies the requirement of the fan blade of the wind turbine for a rolling angle of a cargo-carrying platform. The supercomputing center system provided by the present application can solve the problem of insufficient stability of existing offshore cargo-carrying platforms and realize the islanded grid operation of the offshore supercomputing center.

### DESCRIPTION OF EMBODIMENTS

The technical solutions in embodiments of the present application will be clearly and completely described below with reference to the accompanying drawings in the embodiments of the present application. Obviously, the described embodiments are part of the embodiments of the present application, rather than all of the embodiments. According to the embodiments in the present application, all other embodiments obtained by those skilled in the art without creative efforts fall within the scope of protection of the present application.

The flowcharts shown in the accompanying drawings are only examples and do not necessarily include all contents and operations/steps, nor are they necessarily performed in the order described. For example, some operations/steps can also be decomposed, combined or partially merged, so the actual order of execution may change according to actual conditions.

It should be understood that the terminology used in the specification of the present application is for the purpose of describing particular embodiments only and is not intended to limit the present application. As used in this specification and the appended claims, the singular forms "a/an", "one" and "the" are intended to include the plural forms unless the context clearly dictates otherwise.

It is further to be understood that the term "and/or" as used in this specification and the appended claims refers to and includes any and all possible combinations of one or more of the associated listed items.

In order to facilitate understanding of the embodiments of the present application, some vocabulary involved in the embodiments of the present application are briefly described below.
1. Supercomputing center: a supercomputing center refers to placing multiple supercomputers within one data center. The supercomputing center is used to complete heavy computation tasks in scientific research and engineering projects, including the complex problems such as quantum mechanical computing of the basic properties of atoms, molecular dynamics simulations of drug reaction processes, relativistic simulations of black hole collisions, predictions of atmospheric motion and weather changes, and force computation in bridge design, etc. If the computation is carried out with the use of a single CPU core, it may take months or even years to get the results, but it only takes a day or a few hours to use a supercomputing center integrated with a large number of CPUs.
2. Real-time sea state information: real-time sea state information includes marine conditions within a sea area such as a wind resource distribution parameter, a wave parameter, a tidal level parameter, an ocean current parameter, etc.
3. Damping device: a damping plate of a hull is controlled using a power apparatus, and an inclined angle and an arrangement of the damping plate are adjusted according to different maritime conditions, so as to reduce the turbulence of the water flow and obtain an adjustable hull floating platform.
4. Control device: through the cooperation of a control apparatus and a communication apparatus, the operation and monitoring of a supercomputing center platform, the electric power switching between a wind power generation device and an energy storage device, and the like are completed.
5. Energy storage device: currently, the mature lithium iron phosphate battery energy storage system is used, which mainly includes an energy storage converter, a lithium battery system and a micro-grid EMS energy management system, etc. When offshore wind resources are sufficient and the electric energy generated by the wind power is large, excess electric energy resources are stored; when the electric energy is insufficient, the stored electric energy is released to maintain continuous operation of the supercomputing center system. The energy storage device can be replaced by a new energy storage system, such as being replaced by compressed air energy storage, liquefied air, flywheel energy storage, hydrogen energy storage and other manners, to obtain low-cost energy storage solutions.
6. Islanded grid: islanded grid is an abbreviation of islanded power grid, which refers to a power grid that can operate in isolation.

Existing supercomputing centers are basically located in inland areas. Since the supercomputing center generates huge heat during operation, the associated heat dissipation device consumes a large amount of electric energy. If the supercomputing center is deployed at sea, the stability of the existing offshore cargo-carrying platform cannot satisfy the requirement of a fan blade of a wind turbine for a rolling angle of the cargo-carrying platform. Therefore, it is necessary to provide a supercomputing center system which is based on offshore wind power and has high stability of the cargo-carrying platform.

To this end, embodiments of the present application provide a supercomputing center system, where a control unit generates wind turbine parameter information and damping angle information based on real-time sea state information, and controls a wind power generation device to generate electric energy and adjusts an angle of a damping device based on the wind turbine parameter information and the damping angle information; the wind power generation device supplies electric energy to the entire supercomputing center system according to a deployment signal generated by the control unit; and the stability of the supercomputing center system is improved by using the damping device and a double-vessel connection device combined with a multi-point mooring device, so as to satisfy the requirement of a fan blade of a wind turbine for a rolling angle of a cargo-carrying platform. The supercomputing center system provided by the present application can satisfy the power supply requirement of the offshore supercomputing center system and realize the islanded grid operation of the supercomputing center system.

Some embodiments of the present application will be described in detail below with reference to the accompanying drawings. The following embodiments and features in the embodiments may be combined with each other without conflict.

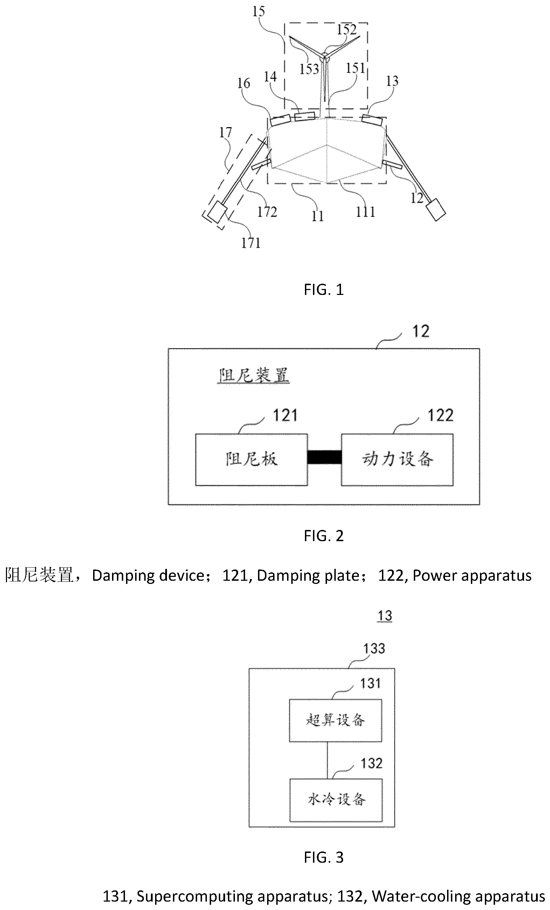

Referring to FIG. 1, which is a schematic structural diagram of a supercomputing center system 100 provided by an embodiment of the present application, the supercomputing center system 100 includes a wind-powered vessel 11, a damping device 12, a supercomputing device 13, a control device 14, and a wind power generation device 15. The wind-powered vessel 11 includes a hull 111, the damping device 12 is connected with the hull 111, and the damping device 12 is configured to maintain the stability of the hull 111. At least one supercomputing device 13 is provided. The supercomputing device 13 is arranged on the hull 111, and the supercomputing device 13 is configured to perform operations. The control device 14 is arranged on the hull 111, and the control device 14 is communicatively connected with the supercomputing device 13 and the damping device 12. The wind power generation device 15 is provided. The wind power generation device 15 is arranged on the hull 111, and the wind power generation device 15 is configured to supply electric energy to the supercomputer device 13, the damping device 12 and the control device 14. The control device 14 is configured to generate wind turbine parameter information and damping angle information according to real-time sea state information of a sea area where the wind-powered vessel 11 is located. The control device 14 controls the wind power generation device 15 to generate electric energy and adjusts an angle of the damping device 12 according to the wind turbine parameter information and the damping angle information, and generates a deployment signal for deploying the electric energy of the wind power generation device 15 according to the amount of electric energy consumption of the control device 14, the damping device 12 and the supercomputing device 13.

Specifically, the wind-powered vessel 11 is used as a cargo-carrying platform. For a structure of the hull 111 of the wind-powered vessel 11, it is needed to calculate, according to the weight and size of the wind power generation device 15, the stability, sway characteristic and motion response characteristic of the hull 111 when the wind power generation device 15 is placed on the to-be-selected wind-powered vessel 11, determine the ballast water characteristic of the to-be-selected wind-powered vessel 11 when equipped with the wind power generation device 15, and select a suitable structure of the hull 111 of the wind-powered vessel 11.

In some embodiments, as shown in FIG. 2, which is a schematic block diagram of a damping device provided by an embodiment of the present application, the damping device 12 includes a damping plate 121 and a power apparatus 122. One end of the power apparatus 122 is connected to the damping plate 121, and the other end of the power apparatus 122 is connected with the hull 111. The power apparatus 122 is electrically connected to the wind power generation device 15 and communicatively connected to the control device 14. The wind power generation device 15 is configured to supply electric energy to the power apparatus 122. The control device 14 is configured to adjust an angle of the damping plate 121 through the power apparatus according to the damping angle information, so as to complete an adjustment of the angle of the damping device 12.

Specifically, multiple damping devices 12 are connected to both sides of the hull 111 in sequence, and different damping angle information is generated according to different sea state information. The damping angle information is that under this sea state information, when an inclined angle of the damping device 12 is maintained at this damping angle, the effect of water turbulence is reduced to a maximum extent and the stability of the supercomputing center system 100 is thus improved.

In some embodiments, as shown in FIG. 3, which is a schematic block diagram of a supercomputing device provided by an embodiment of the present application, the supercomputing device 13 includes a supercomputing apparatus 131, a water-cooling apparatus 132 and a container 133. The container 133 is arranged on the hull 111, and the supercomputing apparatus 131 and the water-cooling apparatus 132 are installed within the container 133. The water-cooling apparatus 132 discharges the heat generated by operations of the supercomputing apparatus 131 into the ocean through its water-cooling circuit to realize the cooling of the supercomputing apparatus 131 and realizes a sealing structure of the container 133 of the supercomputing device 13. Through using the above-mentioned sealing structure of the container 133, the corrosion of internal components by fresh wind from the outside sea surface can be reduced, thereby extending the life of the supercomputing device 13.

In some embodiments, the supercomputing device 13 is placed on a deck of the hull 111. In some embodiments, the supercomputing device 13 is placed within a cabin of the hull 111. The location where the supercomputing device 13 is placed is not limited here.

Specifically, the number of supercomputing devices 13 is obtained by calculation according to electric energy generated by the wind power generation device 15 selected by the supercomputing center system 100, and the heat generated by an operation process of the supercomputing device 13 is calculated according to the number of supercomputing devices 13, so as to arrange a corresponding water-cooling apparatus 132.

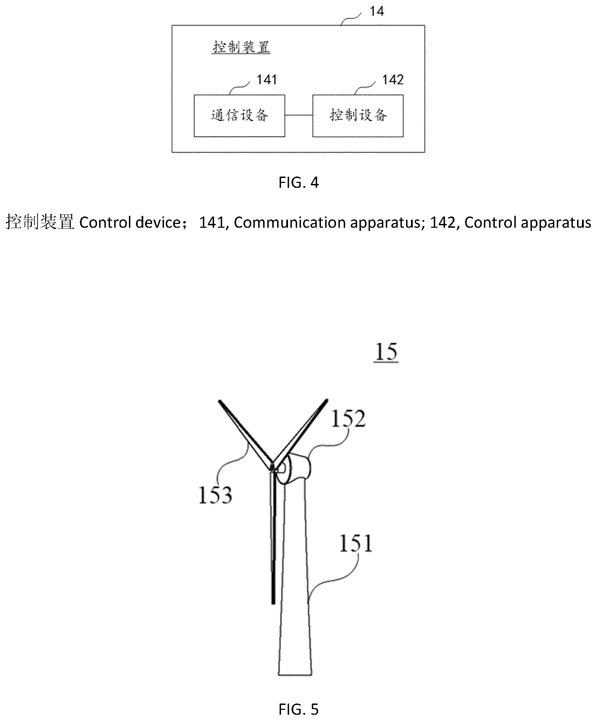

Specifically, as shown in FIG. 4, which is a schematic block diagram of a control device provided by an embodiment of the present application, the control device 14 includes a communication apparatus 141 and a control apparatus 142. The communication apparatus 141 acquires real-time sea state information, and the control apparatus 142 is connected to the communication apparatus 141 for receiving the real-time sea state information and generating wind turbine parameter information and damping angle information according to the real-time sea state information. The control apparatus 142 is connected with the wind power generation device 15, the damping device 12 and the supercomputing device 13. The control apparatus 142 controls the wind power generation device 15 to generate electric energy and adjusts an angle of the damping device 12 according to the wind turbine parameter information and the damping angle information, and generates a deployment signal for deploying the electric energy of the wind power generation device 15 according to the amount of electric energy consumption of the control device 14, the damping device 12 and the supercomputing device 13.

In some embodiments, the supercomputing center system 100 includes a sea state monitoring apparatus. The sea state monitoring apparatus is arranged on the hull 111 and is connected to the control device 14. The sea state monitoring apparatus includes a navigation apparatus, a meteorology apparatus, a communication apparatus and an observation apparatus. The arrangement of the sea state monitoring apparatus can guarantee the safety of the wind-powered vessel 11 during islanded grid operation and assist the control device 14 in generating more accurate real-time sea state signals.

In some embodiments, the communication apparatus generates the real-time sea state information through information transmitted by the corresponding sea state monitoring apparatus arranged on the wind-powered vessel 11. In some embodiments, the communication apparatus generates the real-time sea state information by acquiring data from an external meteorological center. Through the acquisition of the real-time sea state information, an optimal control solution corresponding to the supercomputing center system 100 can be obtained, and the stability of the supercomputing center system 100 can be further improved.

Specifically, the real-time sea state information mainly includes sea state information of the sea area where the supercomputing center system 100 is located currently, such as a wind resource distribution parameter, a wave parameter, a tidal level parameter, an ocean current parameter, etc. The wind turbine parameter information is mainly selected with reference to the wind resource distribution parameter, and the damping angle information is mainly selected with reference to the wave parameter, the tidal level parameter and the ocean current parameter.

Specifically, the communication apparatus is communicatively connected with the supercomputing device 14, and is configured to receive an externally transmitted operation task and transmit it to the supercomputing device 14 for operation, and to receive an operation result of the supercomputing device 14 for external feedback.

In some embodiments, as shown in FIG. 5, which is a schematic structural diagram of a wind power generation device provided by an embodiment of the present application, the wind power generation device 15 includes a tower 151, a wind turbine 152 and at least one fan blade 153. The tower 151 is arranged on the hull 111, and the wind turbine 152 is arranged on a top portion of the tower 151. The fan blade 153 is rotationally connected to the wind turbine 152, and the axial direction corresponding to rotation of the fan blade 153 is set at a preset angle with respect to the bow direction of the wind-powered vessel 11. The wind turbine 152 is electrically connected to the control device 14 and the wind power generation device 15, and the wind power generation device 15 is configured to supply electric energy to the wind turbine 152. The control device 14 is configured to adjust the rotation of the fan blade 153 through the wind turbine 152 according to the wind turbine parameter information, thereby converting offshore wind energy into electric energy.

In some embodiments, the wind power generation device 15 has one fan blade 153. In some embodiments, the wind power generation device 15 has two fan blades 153. In some other embodiments, the wind power generation device 15 has three fan blades 153. The number of fan blades 153 is not limited here.

Specifically, the wind turbine parameter information includes a rotation speed of the fan blade 153 and an axial angle corresponding to the rotation of the fan blade 153. The wind turbine 152 controls the direction and the angle of the rotation of the fan blade 153 through the wind turbine parameter information. During the rotation of the fan blade 153, the offshore wind energy is converted into the electric energy. The wind power generation device 15 receives a deployment signal generated by the control device 14, and deploys the electric energy generated by the wind power generation device 15 to supply electric energy to the control device 14, the damping device 12 and the supercomputing device 13.

In some embodiments, a photovoltaic power generation device is also placed on the hull 111. In some embodiments, a wave-energy power generation device is also placed on the hull 111. In some other embodiments, the photovoltaic power generation device and the wave-energy power generation device are both also placed on the hull 111. The type and number of additional power generation devices placed on the hull 111 are not limited here. Through the step of the multiple-energy power generation devices mentioned above, a comprehensive electric energy supply can be formed in the supercomputing center system 100, and at this time, the energy supply for the supercomputing center system 100 is more stable.

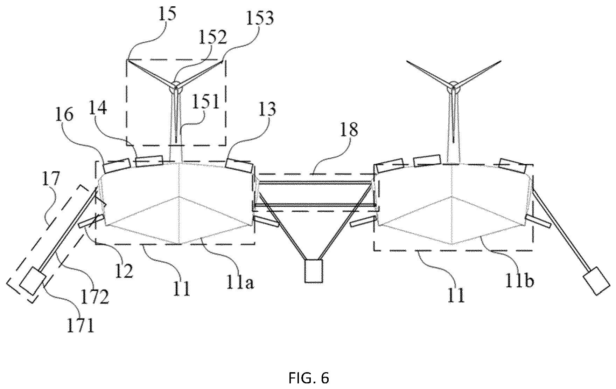

In some embodiments, referring to FIG. 6, the supercomputing center system 100 also includes an energy storage device 16. The energy storage device 16 is arranged on the hull 111. The energy storage device 16 is electrically connected to the wind power generation device 15 for storing electric energy. The energy storage device 16 is also configured to supply electric energy to the supercomputing device 13, the damping device 12 and the control device 14.

In some embodiments, the energy storage device 16 utilizes a lithium iron phosphate battery energy storage system, which mainly includes an energy storage converter, a lithium battery system, a micro-grid EMS energy management system, etc. The above-mentioned energy storage device 16, due to its mature technology, is widely used and can stably realize the storage and release of large-capacity electric energy.

In some embodiments, the energy storage device 16 may use a compressed air energy storage system. In some embodiments, the energy storage device 16 may use a liquefied air energy storage system. In some other embodiments, the energy storage device 16 may use a flywheel energy storage system. In some other embodiments, the energy storage device 16 may use a hydrogen energy storage system. The use of the above-mentioned novel energy storage devices 16 can reduce the overall cost of the energy storage devices 16.

In some embodiments, the generating the deployment signal for deploying the electric energy of the wind power generation device 15 according to the amount of electric energy consumption of the control device 14, the damping device 12 and the supercomputing device 13 includes: comparing, by the control device 14, the electric energy generated by the wind power generation device 15 with the electric energy of the deployment signal; when the electric energy generated by the wind power generation device is greater than the electric energy of the deployment signal, generating, by the control device, a new deployment signal for deploying and transmitting remaining electric energy of the wind power generation device to the energy storage device for storage.

Specifically, when offshore wind resources are sufficient, the electric energy generated by the wind power generation device 15 is relatively large, and excess electric energy can be stored by the energy storage device 16.

In some embodiments, the generating the deployment signal for deploying the electric energy of the wind power generation device 15 according to the amount of electric energy consumption of the control device 14, the damping device 12 and the supercomputing device 13 includes: when the electric energy generated by the wind power generation device 15 is less than the electric energy of the deployment signal, generating, by the control device 14, a new deployment signal for deploying electric energy of the energy storage device 16.

Specifically, when offshore wind resources are scarce, the electric energy generated by the wind power generation device 15 is small and cannot satisfy the electric energy requirements of the supercomputing device 13, the damping device 12 and the control device 14, and a new deployment signal generated by the control device 14 is needed to call the electric energy stored in the energy storage device 16 to maintain the normal operation of the supercomputing center system 100.

In some embodiments, as shown in FIG. 1, the supercomputing center system 100 includes: multiple mooring devices 17. The mooring device includes a counterweight block 171 and a mooring cable 172. One end of the mooring cable 172 is connected to the vessel 111, and the other end of the mooring cable 172 is connected to the counterweight block 171.

In some embodiments, the mooring devices 17 utilize a multi-point mooring structure, and can be used to significantly reduce the degree of rocking of the hull 111.

In some embodiments, the mooring cable 172 utilizes a steel wire rope. Using a steel wire rope as the mooring cable can ensure the stability of the supercomputing center system 100.

In some embodiments, the mooring cable 172 utilizes a high-strength nylon rope. Using a high-strength nylon rope as the mooring cable can reduce the cost of the mooring device 17.

Specifically, the number of mooring devices 17 is related to the degree of rocking of the hull 111. In some embodiments, the number of mooring devices 17 of the supercomputing center system 100 is six. In some embodiments, the number of mooring devices 17 of the supercomputing center system 100 is nine. In some other embodiments, the number of mooring devices 17 of the supercomputing center system 100 is twelve. The number of mooring devices 17 is not limited here.

In some embodiments, as shown in FIG. 6, FIG. 2 is a schematic structural diagram of another supercomputing center system 100. In FIG. 2, the supercomputing center system 100 includes: a first vessel 11a, a second vessel 11b and a connecting device 18, where both the first vessel 11a and the second vessel 11b serve as the wind-powered vessel 11, and the connecting device 18 connects the first vessel 11a and the second vessel 11b.

Specifically, at this time, in the supercomputing center system 100, the first vessel 11a and the second vessel 11b are used as the cargo-carrying platform, and the first vessel 11a and the second vessel 11b are connected through the connecting device 18 in the middle. The damping device 12, the mooring device 17 and the connecting device jointly contribute to the improvement in the stability of the supercomputing center system 100, so that it can satisfy the requirement of the wind power generation device 15 that the rolling angle of the cargo-carrying platform is less than 10 degrees.

Specifically, when the supercomputing center system 100 uses the first vessel 11a and the second vessel 11b as the cargo-carrying platform, it should be ensured that when a new wind blows from the sea, the direction in which the wind power generation device 15 is tilted is towards the direction where the other vessel is located. In some embodiments, the axial direction corresponding to the rotation of the fan blade 153 is set at a preset angle of 85 degrees relative to the bow direction of the wind-powered vessel 11. In some embodiments, the axial direction corresponding to the rotation of the fan blade 153 is set at a preset angle of 90 degrees relative to the bow direction of the wind-powered vessel 11. In some other embodiments, the axial direction corresponding to the rotation of the fan blade 153 is set at a preset angle of 95 degrees relative to the bow direction of the wind-powered vessel 11. The preset angle is not limited here. Through adopting the above preset angle, when the wind power generation device 15 tilts, it can be ensured that a support effect generated by the connecting device 18 and another wind-powered vessel 11 can offset part of tilting force, thereby reducing the rolling angles of the first vessel 11a and the second vessel 11b and improving the stability of the supercomputing center system 100.

Specifically, the connecting device 18 is used to reduce the rolling angle of the cargo-carrying platform of the supercomputing center system 100 and improve the stability of the supercomputing center system 100 by connecting the first vessel 11a and the second vessel 11b. In some embodiments, the connecting device 18 utilizes a box beam structure for connection. In some embodiments, the connecting device 18 utilizes a connecting rod structure formed by multiple horizontal connecting rods and multiple oblique connecting rods for connection. The structural type of the connecting device 18 is not limited here.

As shown in FIG. 6, in some embodiments, the supercomputing center system 100 includes that the mooring cable 172 between the first vessel 11a and the second vessel 11b is connected to the same counterweight block 171. By using the above connection method of the counterweight block 171, the first vessel 11a and the second vessel 11b can be connected more closely, further improving the stability of the supercomputing center system 100.

Specifically, multiple supercomputing center systems 100 including the first vessel 11a and the second vessel 11b are deployed on a large scale to form a supercomputing center cluster based on a maritime islanded grid, thereby achieving a substantial improvement in regional computing capabilities.

In the embodiments of the present application, the control device generates the wind turbine parameter information and the damping angle information according to the real-time sea state information, and also generates deployment information according to an electric energy requirement of the supercomputing center system. The supercomputing center system controls the wind power generation device to generate electric energy through the wind turbine parameter information and the deployment information and to supply electric energy to the entire supercomputing center system, which proposes a green energy supply method to solve the problem of excessive electric energy consumption in existing land-based supercomputing centers. Besides, the angle of the damping device is controlled according to the damping angle information, and the damping device and a double-vessel connection device combined with a multi-point mooring device is adopted, improving the stability of the supercomputing center system and satisfying the requirement of the fan blade of the wind turbine for the rolling angle of the cargo-carrying platform. The supercomputing center system provided by the present application can satisfy the electric energy supply requirement of the offshore supercomputing center system and realize the islanded grid operation of the supercomputing center system.

The above are only specific embodiments of the present application, but the protection scope of the present application is not limited thereto. Those skilled in the art can easily think of various equivalent modifications or replacements within the technical scope disclosed in the present application. These modifications or replacements shall be covered by the protection scope of the present application. Therefore, the protection scope of the present application should be defined by the protection scope of the claims.

## Claims

1. A supercomputing center system, comprising:
a wind-powered vessel, comprising a hull;
a damping device, connected with the hull and configured to maintain stability of the hull;
at least one supercomputing device, arranged on the hull and configured to perform operations;
a control device, arranged on the hull and communicatively connected with the supercomputing device and the damping device;
a wind power generation device, arranged on the hull and configured to supply electric energy to the supercomputing device, the damping device and the control device;
wherein the control device is configured to: generate wind turbine parameter information and damping angle information according to real-time sea state information of a sea area where the wind-powered vessel is located, and control the wind power generation device to generate electric energy and adjust an angle of the damping device according to the wind turbine parameter information and the damping angle information; and generate a deployment signal for deploying the electric energy of the wind power generation device according to amount of electric energy consumption of the control device, the damping device and the supercomputing device.

2. The supercomputing center system according to claim 1, wherein the damping device comprises:
a damping plate;
a power apparatus, one end of the power apparatus being connected to the damping plate, and the other end being connected with the hull;
wherein the power apparatus is electrically connected to the wind power generation device, and the power apparatus is communicatively connected to the control device; the wind power generation device is configured to supply electric energy to the power apparatus, and the control device is configured to adjust an angle of the damping plate through the power apparatus according to the damping angle information.

3. The supercomputing center system according to claim 1, wherein the supercomputing device comprises:
a container, arranged on the hull;
a supercomputing apparatus and a water-cooling apparatus, the supercomputing apparatus and the water-cooling apparatus being installed within the container and the water-cooling apparatus being configured to cool the supercomputing apparatus.

4. The supercomputing center system according to claim 1, wherein the wind power generation device comprises:
a tower, arranged on the hull;
a wind turbine, arranged on a top portion of the tower;
at least one fan blade, rotationally connected to the wind turbine, and an axial direction corresponding to rotation of the fan blade being set at a preset angle with respect to a bow direction of the wind-powered vessel;
wherein the wind turbine is electrically connected to the control device and the wind power generation device, the wind power generation device is configured to supply electric energy to the wind turbine, and the control device is configured to adjust the rotation of the fan blade through the wind turbine according to the wind turbine parameter information.

5. The supercomputing center system according to claim 1, wherein the supercomputing center system comprises:
an energy storage device, arranged on the hull, wherein the energy storage apparatus is electrically connected to the wind power generation device and is configured to store electric energy, and the energy storage device is further configured to supply electric energy to the supercomputing device, the damping device and the control device.

6. The supercomputing center system according to claim 5, wherein the generating the deployment signal for deploying the electric energy of the wind power generation device according to the amount of electric energy consumption of the control device, the damping device and the supercomputing device comprises:
comparing, by the control device, the electric energy generated by the wind power generation device with the electric energy of the deployment signal;
when the electric energy generated by the wind power generation device is greater than the electric energy of the deployment signal, generating, by the control device, a new deployment signal for deploying and transmitting remaining electric energy of the wind power generation device to the energy storage device for storage.

7. The supercomputing center system according to claim 6, wherein the generating the deployment signal for deploying the electric energy of the wind power generation device according to the amount of electric energy consumption of the control device, the damping device and the supercomputing device comprises:
when the electric energy generated by the wind power generation device is less than the electric energy of the deployment signal, generating, by the control device, a new deployment signal for deploying electric energy of the energy storage device.

8. The supercomputing center system according to claim 1, wherein the supercomputing center system comprises:
multiple mooring devices, wherein a mooring device comprises a mooring cable and a counterweight block, one end of the mooring cable being connected to the vessel, and the other end of the mooring cable being connected to the counterweight block.

9. The supercomputing center system according to claim 8, wherein the supercomputing center system comprises:
a first vessel and a second vessel, wherein both the first vessel and the second vessel serve as the wind-powered vessel;
a connecting device, connecting the first vessel and the second vessel.

10. The supercomputing center system according to claim 9, wherein the supercomputing center system comprises:
the mooring cable between the first vessel and the second vessel being connected to the same counterweight block.
